# EUROPEAN PATENT APPLICATION

(11) **EP 4 489 541 A1**
(43) Date of publication of application: **08.01.2025**
(21) Application number: 24166568.6
(22) Date of filing: 26.03.2024
(51) Int. Cl.: H10B 12/00, H01L 21/768

(54) **SEMICONDUCTOR DEVICE**

(30) Priority: 05.07.2023 KR 20230087073
(71) Applicant: Samsung Electronics Co., Ltd., Suwon-si, Gyeonggi-do 16677 (KR)
(72) Inventor: CHANG, Jihoon, 16677 Suwon-si (KR); KIM, Changsik, 16677 Suwon-si (KR); SONG, Jaejoon, 16677 Suwon-si (KR)
(74) Representative: Marks & Clerk LLP

(57) **Abstract**

A semiconductor device includes a substrate, a first transistor and a second transistor on the substrate, a bit line electrically connected to the first transistor, a channel layer on the bit line, a gate insulating layer on the channel layer, a word line on the gate insulating layer, a landing pad electrically connected to the channel layer, a connection pad electrically connected to the word line and the second transistor, and a division structure separating the landing pad from the connection pad. The division structure includes an intervening portion between the landing pad and the connection pad.

## Description

The present disclosure relates to a semiconductor device, and in particular, to a semiconductor device including vertical channel transistors.

### BACKGROUND

As a semiconductor device is scaled down, it may be necessary to develop a fabrication technology capable of increasing an integration density of a semiconductor device and improving an operation speed and a production yield. Thus, semiconductor devices with vertical channel transistors have been suggested to increase an integration density of a semiconductor device and improve resistance and current driving characteristics of transistors.

### SUMMARY

Some embodiments of the inventive concepts provide a semiconductor device with improved electrical characteristics and a high integration density.

According to an embodiment of the inventive concept, a semiconductor device may include a substrate, a first transistor and a second transistor on the substrate, a bit line electrically connected to the first transistor, a channel layer on the bit line, a gate insulating layer on the channel layer, a word line on the gate insulating layer, a landing pad electrically connected to the channel layer, a connection pad electrically connected to the word line and the second transistor, and a division structure separating the landing pad from the connection pad. The division structure may include an intervening portion between the landing pad and the connection pad, and the intervening portion may include a first side surface in contact with the landing pad and a second side surface in contact with the connection pad.

According to an embodiment of the inventive concept, a semiconductor device may include a substrate, a first transistor and a second transistor on the substrate, a bit line electrically connected to the first transistor, a channel layer on the bit line, a gate insulating layer on the channel layer, a word line on the gate insulating layer, a landing pad electrically connected to the channel layer, and a first connection pad electrically connected to the word line and the second transistor. The first connection pad may overlap a first end portion of the word line in plan view, and a top surface of the landing pad may be at a substantially same level as a top surface of the first connection pad relative to the substrate.

According to an embodiment of the inventive concept, a semiconductor device may include a substrate, a first transistor and a second transistor on the substrate, a lower insulating structure on the first transistor and the second transistor, a first interlayer insulating layer on the lower insulating structure, a second interlayer insulating layer on the first interlayer insulating layer, a bit line in the second interlayer insulating layer, a conductive connection pattern in the first interlayer insulating layer, a channel layer on the bit line, a gate insulating layer on the channel layer, a word line on the gate insulating layer, a gate capping pattern on the word line, a landing pad and a connection pad on the gate capping pattern, a division structure separating the landing pad from the connection pad, and a data storage pattern on the landing pad. The landing pad may be electrically connected to the first transistor through the channel layer and the bit line, and the connection pad may be electrically connected to the word line. The connection pad may be electrically connected to the second transistor through the conductive connection pattern.

According to an embodiment of the inventive concept, a method of fabricating a semiconductor device may include forming a first transistor and a second transistor on a substrate, forming a bit line and a conductive connection pattern, which are electrically connected to the first transistor and the second transistor, respectively, forming a channel layer on the bit line, forming a gate insulating layer on the channel layer, forming a word line on the gate insulating layer, forming a gate capping pattern on the word line, forming a preliminary pad structure on the gate capping pattern, and patterning the preliminary pad structure to form a landing pad and a connection pad. The landing pad may be electrically connected to the bit line, and the connection pad may be electrically connected to the conductive connection pattern.

At least some of the above and other features of the invention are set out in the claims.

### BRIEF DESCRIPTION OF THE DRAWINGS

FIG. 1 is a block diagram illustrating a semiconductor device according to an embodiment of the inventive concept.
FIGS. 2 and 3 are perspective views schematically illustrating a semiconductor device according to an embodiment of the inventive concept.
FIG. 4A is a plan view illustrating a semiconductor device according to an embodiment of the inventive concept.
FIG. 4B is a sectional view taken along a line A-A' of FIG. 4A.
FIG. 4C is a sectional view taken along a line B-B' of FIG. 4A.
FIG. 4D is an enlarged sectional view illustrating a portion E1 of FIG. 4B.
FIG. 4E is an enlarged sectional view illustrating a portion E2 of FIG. 4C.
FIGS. 5A, 5B, 6A, 6B, 7A, 7B, 8A, 8B, 9, 10, 11A, 11B, 12, and 13 are sectional views illustrating a method of fabricating a semiconductor device, according to an embodiment of the inventive concept.
FIG. 14A is a plan view illustrating a semiconductor device according to an embodiment of the inventive concept.
FIG. 14B is a sectional view taken along a line C-C' of FIG. 14A.
FIG. 15 is a plan view illustrating a semiconductor device according to an embodiment of the inventive concept.
FIG. 16 is a plan view illustrating a semiconductor device according to an embodiment of the inventive concept.
FIG. 17 is a plan view illustrating a semiconductor device according to an embodiment of the inventive concept.

### DETAILED DESCRIPTION OF EMBODIMENTS

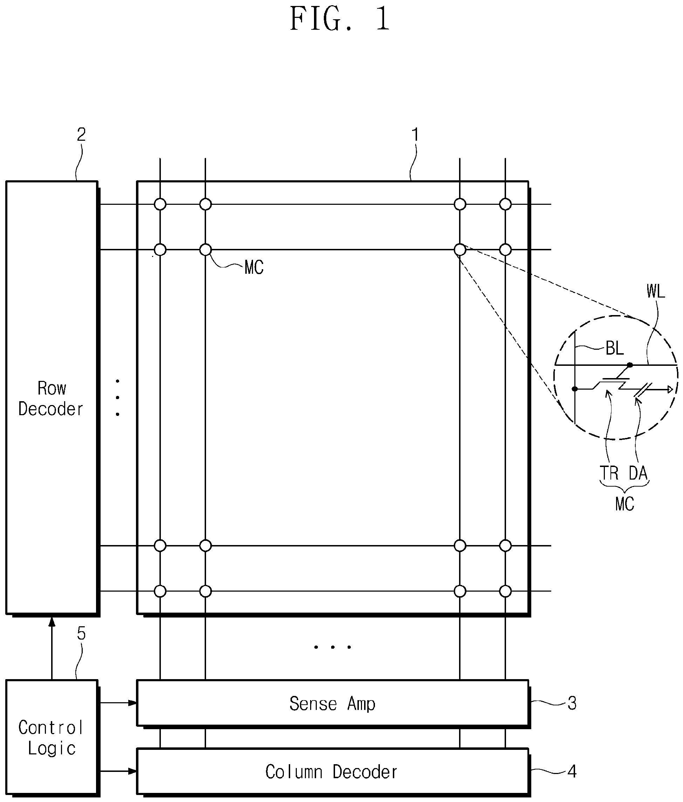

FIG. 1 is a block diagram illustrating a semiconductor device according to an embodiment of the inventive concept.

Referring to FIG. 1, a semiconductor device may include a memory cell array 1, a row decoder 2, a sense amplifier 3, a column decoder 4, and a control logic 5. The terms "comprises," "comprising," "includes" and/or "including," when used herein, specify the presence of stated elements, but do not preclude the presence of additional elements.

The memory cell array 1 may include a plurality of memory cells MC, which are two- or three-dimensionally arranged. Each of the memory cells MC may be provided between and connected to a word line WL and a bit line BL, which are provided to cross or intersect each other.

Each of the memory cells MC may include a selection element TR and a data storing element DA. The selection element TR and the data storing element DA may be electrically connected to each other. The selection element TR may be connected to both the word line WL and the bit line BL. In other words, the selection element TR may be provided at an intersection of the word and bit lines WL and BL.

The selection element TR may include a field effect transistor. The data storing element DA may include a capacitor, a magnetic tunnel junction pattern, or a variable resistor. As an example, the selection element TR may be a transistor whose gate, source, and drain terminals are connected to the word line WL, the bit line BL, and the data storing element DA, respectively.

The row decoder 2 may be configured to decode address information, which is input from the outside (e.g., from an external device), and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which is selected based on address information decoded by the column decoder 4, and a reference bit line.

The column decoder 4 may establish a data transmission path between the sense amplifier 3 and an external device (e.g., a memory controller). The column decoder 4 may be configured to decode address information, which is input from the outside, and to select one of the bit lines BL, based on the decoded address information.

The control logic 5 may generate control signals, which are used to control an operation of writing or reading data to or from the memory cell array 1.

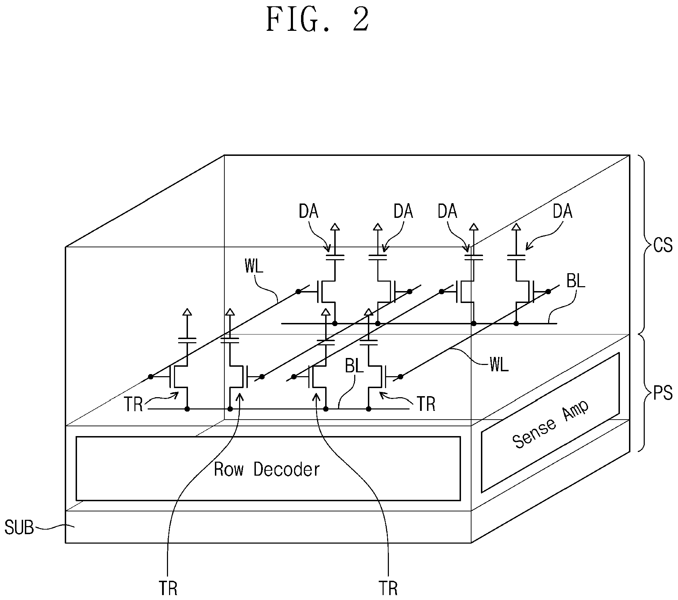

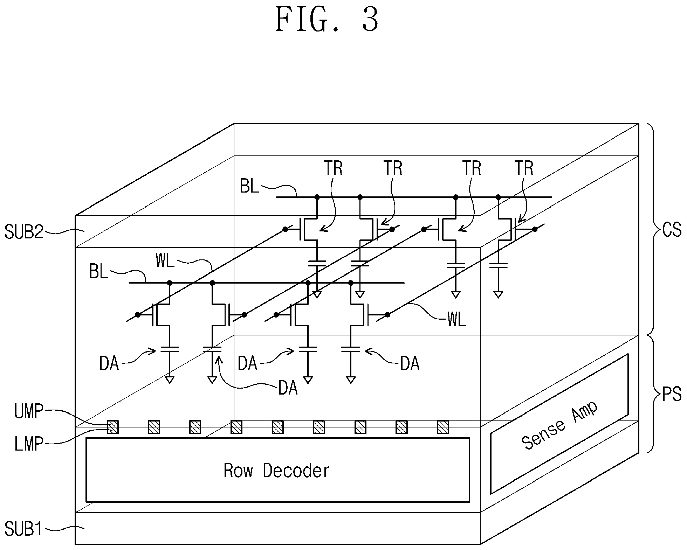

FIGS. 2 and 3 are perspective views schematically illustrating a semiconductor device according to an embodiment of the inventive concept.

Referring to FIGS. 2 and 3, the semiconductor device may include a peripheral circuit structure PS and a cell array structure CS that are connected to each other. The term "connected" or "connecting" may be used herein to refer to a physical and/or electrical connection. The term "separated" or "separating" may be used herein to refer to physical separation and/or electrical isolation.

The peripheral circuit structure PS may include core and peripheral circuits formed on a substrate SUB. The core and peripheral circuits may include the row and column decoders 2 and 4, the sense amplifier 3, and the control logic 5 described with reference to FIG. 1.

The cell array structure CS may include a memory cell array (e.g., 1 of FIG. 1), in which memory cells (e.g., MC of FIG. 1) are two- or three-dimensionally arranged. Each of the memory cells MC may include the selection element TR and the data storing element DA, as described above.

In an embodiment, the selection element TR of each of the memory cells (e.g., MC of FIG. 1) may include a vertical channel transistor (VCT). The vertical channel transistor may be configured to have a channel region whose lengthwise direction is substantially normal to a top surface of the substrate SUB. The data storing element DA of each of the memory cells (e.g., MC of FIG. 1) may include a capacitor.

In the embodiment of FIG. 2, the peripheral circuit structure PS may be provided on the substrate SUB, and the cell array structure CS may be provided on the peripheral circuit structure PS.

In the embodiment of FIG. 3, the peripheral circuit structure PS may be provided on a first substrate SUB1, and the cell array structure CS may be provided on a second substrate SUB2 that is disposed to face the first substrate SUB1. The terms "first," "second," etc., may be used herein merely to distinguish one component, layer, direction, etc. from another.

First metal pads LMP may be provided in the uppermost portion of the peripheral circuit structure PS. The first metal pads LMP may be electrically connected to the core and peripheral circuits (e.g., 2, 3, 4, and 5 of FIG. 1). Spatially relative terms such as "above," "upper," 'below,' 'lower,' "side," and the like are intended to encompass different orientations of the device in use or operation in addition to the orientation depicted in the figures. For example, if the device in the figures is turned over, elements described as "below" or "beneath" other elements or features would then be oriented "above" the other elements or features. The device may be otherwise oriented (rotated 90 degrees or at other orientations), and the spatially relative descriptors used herein may be interpreted accordingly.

Second metal pads UMP may be provided in the lowermost portion of the cell array structure CS. The second metal pads UMP may be electrically connected to the memory cell array (e.g., 1 of FIG. 1). The second metal pads UMP may be directly bonded to (i.e., in direct contact with) the first metal pads LMP of the peripheral circuit structure PS. When components or layers are referred to herein as "directly" on or in contact or connected, no intervening components or layers are present.

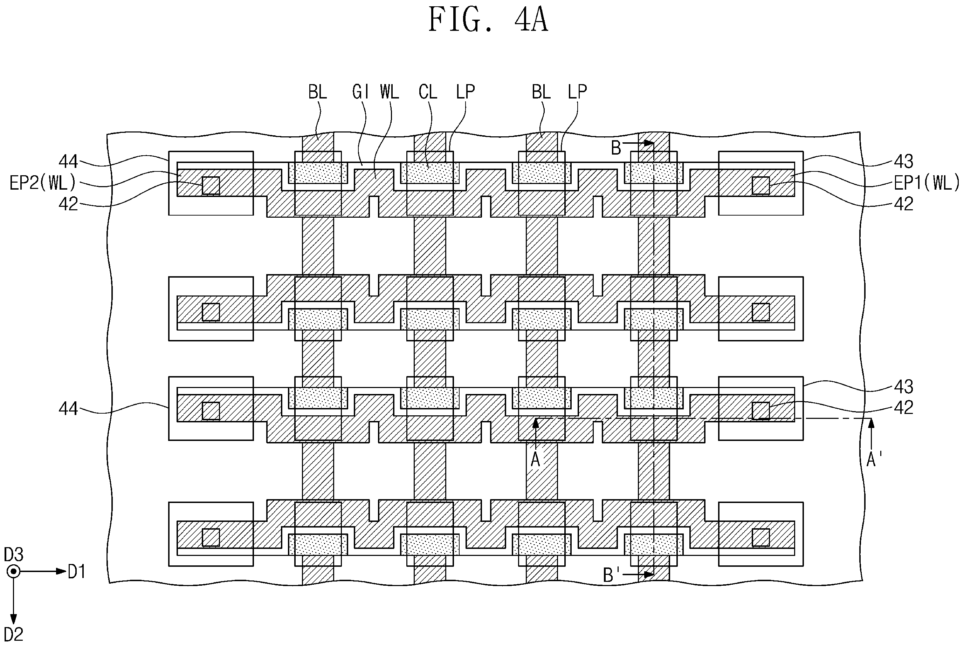

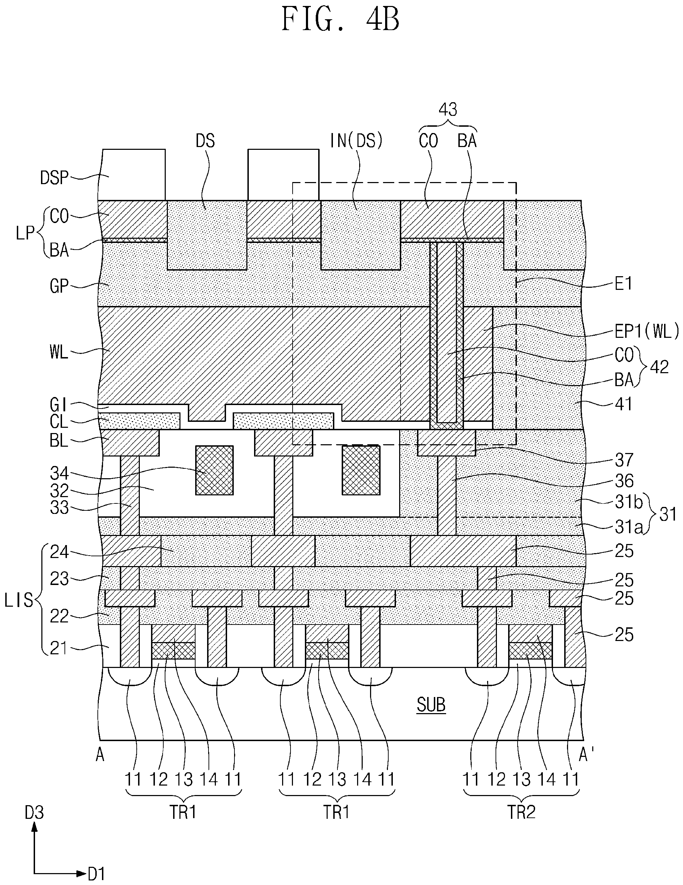

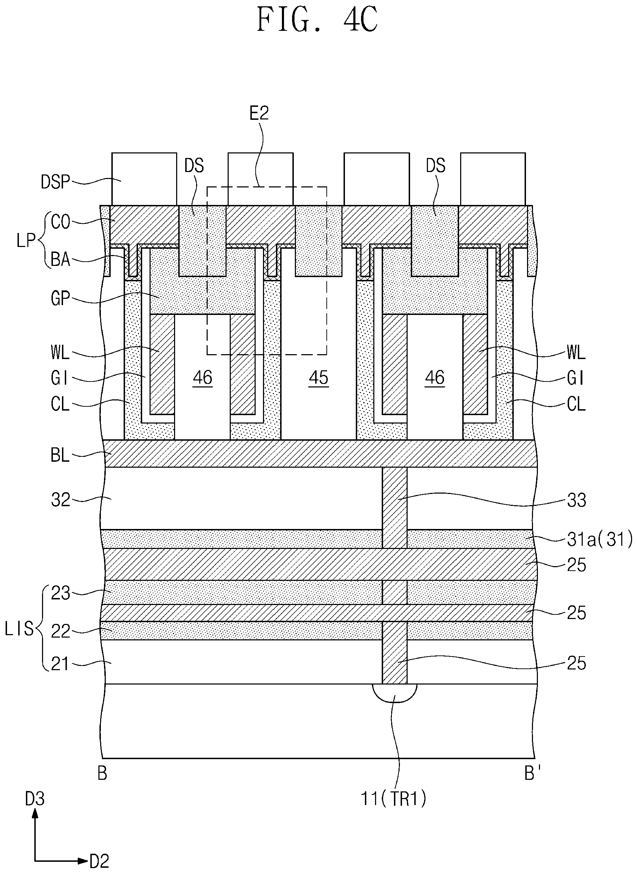

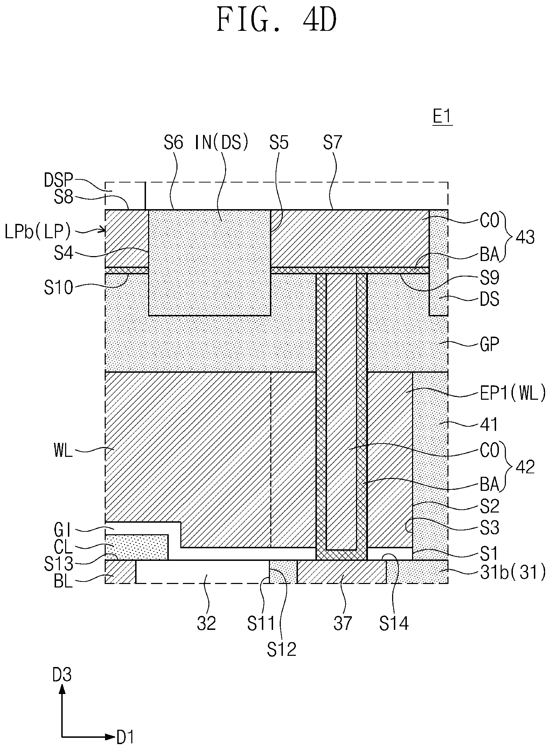

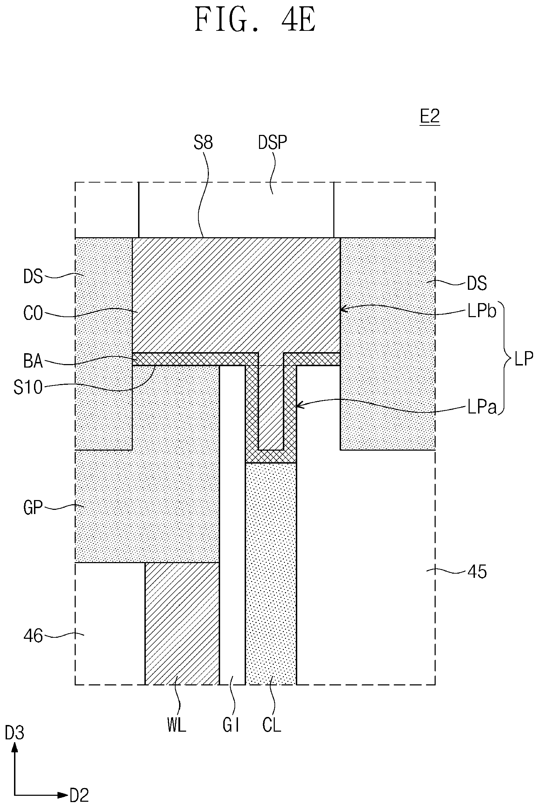

FIG. 4A is a plan view illustrating a semiconductor device according to an embodiment of the inventive concept. FIG. 4B is a sectional view taken along a line A-A' of FIG. 4A. FIG. 4C is a sectional view taken along a line B-B' of FIG. 4A. FIG. 4D is an enlarged sectional view illustrating a portion E1 of FIG. 4B. FIG. 4E is an enlarged sectional view illustrating a portion E2 of FIG. 4C.

Referring to FIGS. 4A to 4C, a lower insulating structure LIS may be provided on the substrate SUB. The substrate SUB may be a plate-shaped structure (e.g., having a planar surface) that extends parallel to a plane defined by a first direction D1 and a second direction D2. The first and second directions D1 and D2 may be non-parallel to each other. In an embodiment, the first and second directions D1 and D2 may be two different horizontal directions, which are orthogonal to each other.

The lower insulating structure LIS may include a first lower insulating layer 21 on the substrate SUB, a second lower insulating layer 22 on the first lower insulating layer 21, a third lower insulating layer 23 on the second lower insulating layer 22, and a fourth lower insulating layer 24 on the third lower insulating layer 23.

The first to fourth lower insulating layers 21, 22, 23, and 24 may include at least one insulating material. As an example, the first lower insulating layer 21 may be formed of or include an oxide material, and at least one of the second to fourth lower insulating layers 22, 23, and 24 may be formed of or include a nitride material.

A first transistor TR1 and a second transistor TR2 may be provided on the substrate SUB. The first transistor TR1 and the second transistor TR2 may be provided between the substrate SUB and the lower insulating structure LIS. The lower insulating structure LIS may cover the first transistor TR1 and the second transistor TR2.

Each of the first and second transistors TR1 and TR2 may include impurity regions 11, a peripheral gate insulating layer 12, a first peripheral gate conductive layer 13, and a second peripheral gate conductive layer 14. The impurity regions 11 may be formed by doping the substrate SUB with impurities. The peripheral gate insulating layer 12 may include an insulating material. The first and second peripheral gate conductive layers 13 and 14 may include at least one conductive material. As an example, the first peripheral gate conductive layer 13 may be formed of or include polysilicon, and the second peripheral gate conductive layer 14 may be formed of or include a metallic material.

Lower conductive patterns 25 may be provided in the lower insulating structure LIS. The lower conductive pattern 25 may be electrically connected to the first transistor TR1 or the second transistor TR2. The lower conductive pattern 25 may be enclosed by at least one of the first to fourth lower insulating layers 21, 22, 23, and 24. The lower conductive patterns 25 may include at least one of conductive contact plugs, conductive lines, or conductive pads. The term "surround" or "cover" or "fill" or "enclose" as may be used herein may not require completely surrounding or covering or filling or enclosing the described elements or layers, but may, for example, refer to partially surrounding or covering or filling the described elements or layers. The lower conductive pattern 25 may be formed of or include at least one conductive material.

In an embodiment, the first and second transistors TR1 and TR2, the lower insulating structure LIS and the lower conductive pattern 25 may constitute the peripheral circuit structure PS described with reference to FIG. 2. In an embodiment, the first transistor TR1 may be used as a part of the sense amplifier 3 described with reference to FIG. 1. In an embodiment, the second transistor TR2 may be used as a part of a sub-word-line driver.

A first interlayer insulating layer 31 may be provided on the lower insulating structure LIS. The first interlayer insulating layer 31 may include a lower portion 31a and an upper portion 31b. A second interlayer insulating layer 32 may be provided on the lower portion 31a of the first interlayer insulating layer 31. The upper portion 31b of the first interlayer insulating layer 31 may be provided at the same level as the second interlayer insulating layer 32. The term "level" as used herein may refer to a relative distance from a reference point/element/surface, such as a surface of the substrate SUB. A top surface of the upper portion 31b of the first interlayer insulating layer 31 may be located at the same level as a top surface of the second interlayer insulating layer 32. The second interlayer insulating layer 32 may be provided in the first interlayer insulating layer 31. The first and second interlayer insulating layers 31 and 32 may be formed of or include at least one insulating material. As an example, the first interlayer insulating layer 31 may be formed of or include at least one nitride material, and the second interlayer insulating layer 32 may be formed of or include at least one oxide material.

A plurality of bit lines BL may be provided in the second interlayer insulating layer 32. The bit lines BL may extend in the second direction D2. The bit lines BL may be arranged in the first direction D1. The bit lines BL may be spaced apart from each other in the first direction D1. The number of the bit lines BL may not be limited to that in the illustrated example. In an embodiment, five or more bit lines BL may be provided.

The bit lines BL may be formed of or include at least one conductive material. In an embodiment, the bit lines BL may be formed of or include at least one of a doped semiconductor material (e.g., doped silicon and/or doped germanium), a conductive metal nitride material (e.g., titanium nitride and/or tantalum nitride), a metallic material (e.g., tungsten, titanium, and/or tantalum), or a metal-semiconductor compound (e.g., tungsten silicide, cobalt silicide, and/or titanium silicide). The bit line BL may be a single conductive layer or a multiple conductive layer.

First contacts 33 may be provided. The first contact 33 may connect the bit line BL to the lower conductive pattern 25. The bit line BL may be electrically connected to the first transistor TR1 through the first contact 33 and the lower conductive patterns 25. The first contact 33 may be enclosed by the second interlayer insulating layer 32 and the lower portion 31a of the first interlayer insulating layer 31. The first contact 33 may be formed of or include at least one conductive material.

Shielding patterns 34 may be provided in the second interlayer insulating layer 32. The shielding patterns 34 may be formed of or include at least one conductive material. The shielding patterns 34 may serve as an electrical shielding layer.

A conductive connection pattern 37 may be provided in the upper portion 3 1b of the first interlayer insulating layer 31. The conductive connection pattern 37 may be a conductive line or a conductive pad. The conductive connection pattern 37 may be formed of or include at least one conductive material.

A second contact 36 may be provided. The second contact 36 may connect the conductive connection pattern 37 to the lower conductive pattern 25. The conductive connection pattern 37 may be electrically connected to the second transistor TR2 through the second contact 36 and the lower conductive patterns 25. The second contact 36 may be enclosed by the upper and lower portions 31b and 31a of the first interlayer insulating layer 31. The second contact 36 may be formed of or include at least one conductive material.

Channel layers CL may be provided on the bit lines BL. Each of the bit lines BL may be in contact with a plurality of channel layers CL. The channel layers CL on each of the bit lines BL may be arranged in the second direction D2.

The channel layer CL may be formed of or include at least one semiconductor material or oxide semiconductor material. For example, the oxide semiconductor materials may include at least one of InGaZnO, InGaSiO, InSnZnO, InZnO, ZnO, ZnSnO, ZnON, ZrZnSnO, SnO, HfInZnO, GaZnSnO, AlZnSnO, YbGaZnO, or InGaO. The semiconductor material may be formed of or include at least one of, for example, Si or Ge. In an embodiment, the channel layer CL may have a multi-layered structure including a plurality of layers. In an embodiment, the channel layer CL may include a two-dimensional material.

A gate insulating layer GI may be provided on the channel layers CL. In an embodiment, each gate insulating layer GI may be in contact with a plurality of channel layers CL. The gate insulating layer GI may be formed of or include at least one insulating material. As an example, the gate insulating layer GI may be formed of or include at least one oxide material.

The word line WL may be provided on the gate insulating layer GI. The word line WL may include a conductive material. For example, the word line WL may be formed of or include at least one of a doped semiconductor material (e.g., doped silicon and/or doped germanium), a conductive metal nitride material (e.g., titanium nitride and/or tantalum nitride), a metallic material (e.g., tungsten, titanium, and/or tantalum), or a metal-semiconductor compound (e.g., tungsten silicide, cobalt silicide, and/or titanium silicide).

The word line WL may include a first end portion EP1 and a second end portion EP2. The first and second end portions EP1 and EP2 may be spaced apart from each other in the first direction D1. A plurality of channel layers CL may be provided between the first and second end portions EP1 and EP2. The number of the channel layers CL disposed between the first and second end portions EP1 and EP2 may not be limited to that in the illustrated example.

The first end portion EP1 may be a portion of the word line WL overlapping a first connection pad 43, which will be described below, in a third direction D3. The second end portion EP2 may be a portion of the word line WL that overlaps a second connection pad 44, which will be described below, in the third direction D3. Components or layers described with reference to "overlap" in a particular direction may be at least partially obstructed by one another when viewed along a line extending in the particular direction or in a plane perpendicular to the particular direction. The third direction D3 may be non-parallel to the first and second directions D1 and D2. As an example, the third direction D3 may be a vertical direction orthogonal to the first and second directions D1 and D2. The third direction D3 may define a height direction. For instance, height may represent a relative position along the third direction D3 (e.g. a distance from the substrate SUB along the third direction D3). Accordingly, features or components that are described above other features or components may be located further along the third direction D3 (e.g. further from the substrate SUB) than the other features or components. Similarly, a "top" part of a feature or component may be a part that is furthest along the third direction D3.

A first molding insulating layer 46 and a second molding insulating layer 45 may be provided on the bit line BL. A side surface of the first molding insulating layer 46 may be in contact with the word line WL, the gate insulating layer GI, and the channel layer CL. A side surface of the second molding insulating layer 45 may be in contact with the channel layer CL and a landing pad LP, which will be described below. The first and second molding insulating layers 46 and 45 may be alternately arranged in the second direction D2. The first and second molding insulating layers 46 and 45 may be formed of or include at least one insulating material. In an embodiment, each of the first and second molding insulating layers 46 and 45 may have a multi-layered structure including a plurality of insulating layers. In an embodiment, an air gap may be provided in each of the first and second molding insulating layers 46 and 45.

A filling insulating layer 41 may be provided on the upper portion 31b of the first interlayer insulating layer 31. The filling insulating layer 41 may be in contact with the first end portion EP1 of the word line WL. The filling insulating layer 41 may be formed of or include at least one insulating material. As an example, the filling insulating layer 41 may be formed of or include at least one nitride material. In an embodiment, the filling insulating layer 41 may have a multi-layered structure including a plurality of insulating layers.

A gate capping pattern GP may be provided on the word lines WL, the first molding insulating layer 46, and the filling insulating layer 41. The gate capping pattern GP may be provided between the gate insulating layers GI, which are spaced apart from each other in the second direction D2. The gate capping pattern GP may be provided on a top surface of the word line WL. The gate capping pattern GP may be formed of or include at least one insulating material. As an example, the gate capping pattern GP may be formed of or include at least one nitride material. In an embodiment, the gate capping pattern GP may have a multi-layered structure including a plurality of insulating layers. In an embodiment, the gate capping pattern GP may be formed of or include the same material as the filling insulating layer 41. In an embodiment, the gate capping pattern GP may be formed of or include a material different from the filling insulating layer 41.

Landing pads LP may be provided. The landing pad LP may be provided on the channel layer CL and the gate capping pattern GP. The landing pad LP may be in contact with the channel layer CL and the gate capping pattern GP. The landing pad LP may include a barrier layer BA and a conductive layer CO. The barrier layer BA of the landing pad LP may be in contact with the channel layer CL and the gate capping pattern GP. The conductive layer CO of the landing pad LP may be provided on the barrier layer BA of the landing pad LP. The barrier and conductive layers BA and CO of the landing pad LP may be formed of or include at least one conductive material. As an example, the barrier layer BA of the landing pad LP may be formed of or include at least one of titanium or tantalum, and the conductive layer CO of the landing pad LP may be formed of or include tungsten.

The landing pad LP may be electrically connected to the channel layer CL. The landing pad LP may be electrically connected to the first transistor TR1 through the channel layer CL, the bit line BL, the first contact 33, and the lower conductive patterns 25.

First and second connection pads 43 and 44 may be provided. The first and second connection pads 43 and 44 may be provided on the gate capping pattern GP. The first and second connection pads 43 and 44 may be in contact with the gate capping pattern GP. Each of the word lines WL may overlap one of the first connection pads 43 and one of the second connection pads 44 in the third direction D3. The first and second connection pads 43 and 44, which overlap one of the word lines WL in the third direction D3, may be spaced apart from each other in the first direction D1. The landing pads LP, which are placed between the first and second connection pads 43 and 44 commonly overlap one of the word lines WL in the third direction D3, may be arranged in the first direction D1. The first connection pads 43 may be arranged in the second direction D2. The second connection pads 44 may be arranged in the second direction D2. A width of each of the first and second connection pads 43 and 44 in the second direction D2 may be equal to a width of the landing pad LP in the second direction D2.

Each of the first and second connection pads 43 and 44 may include the barrier layer BA and the conductive layer CO on the barrier layer BA. The barrier layer BA of each of the first and second connection pads 43 and 44 may be formed of or include the same conductive material as the barrier layer BA of the landing pad LP. The conductive layer CO of each of the first and second connection pads 43 and 44 may be formed of or include the same conductive material as the conductive layer CO of the landing pad LP.

The gate capping pattern GP may be provided between the landing pad LP and the word line WL. The gate capping pattern GP may be provided between the first connection pad 43 and the word line WL. The gate capping pattern GP may be provided between the second connection pad 44 and the word line WL.

Penetration contacts 42 may be provided. The penetration contact 42 may be in contact with the gate capping pattern GP, the word line WL, and the gate insulating layer GI. The penetration contact 42 may be provided to penetrate the gate capping pattern GP, the word line WL, and the gate insulating layer GI. The penetration contact 42 may be enclosed by the gate capping pattern GP, the word line WL, and the gate insulating layer GI. The penetration contact 42 may penetrate the first or second end portion EP1 or EP2 of the word line WL. A top surface of the penetration contact 42 may be in contact with a bottom surface of the first connection pad 43 or a bottom surface of the second connection pad 44. A bottom surface of the penetration contact 42 may be in contact with a top surface of the conductive connection pattern 37.

A penetration contact 42 may electrically connect the first connection pad 43 to the word line WL and a second transistor TR2. A penetration contact 42 may electrically connect the second connection pad 44 to the word line WL and a second transistor TR2. The first connection pad 43 may be electrically connected to the word line WL through a respective penetration contact 42. The second connection pad 44 may be electrically connected to the word line WL through a respective penetration contact 42. The first connection pad 43 may be electrically connected to a second transistor TR2 through a respective penetration contact 42, the conductive connection pattern 37, the second contact 36, and the lower conductive patterns 25. The second connection pad 44 may be electrically connected to a second transistor TR2 through a respective penetration contact 42, the conductive connection pattern 37, the second contact 36, and the lower conductive patterns 25.

The penetration contact 42 may include the barrier layer BA, which is in contact with the word line WL, the gate capping pattern GP, the gate insulating layer GI, and the conductive connection pattern 37, and the conductive layer CO, which is enclosed by the barrier layer BA. The barrier layer BA of the penetration contact 42 may be formed of or include the same conductive material as the barrier layer BA of the landing pad LP. The conductive layer CO of the penetration contact 42 may be formed of or include the same conductive material as the conductive layer CO of the landing pad LP.

The first connection pad 43, the first end portion EP1 of the word line WL, and the conductive connection pattern 37 may overlap each other in the third direction D3. The first connection pad 43, the penetration contact 42, and the conductive connection pattern 37 may overlap each other in the third direction D3.

A division structure DS may be provided to separate the landing pads LP, the first connection pads 43, and the second connection pads 44 from each other. The division structure DS may be provided on the gate capping pattern GP. The division structure DS may be formed of or include at least one insulating material. In an embodiment, the division structure DS may have a multi-layered structure including a plurality of insulating layers.

The division structure DS may include an intervening portion IN interposed between the first connection pad 43 and the landing pad LP. The intervening portion IN may separate (i.e., physically and electrically separate or isolate) the first connection pad 43 from the landing pad LP.

Data storage patterns DSP may be provided on and connected to the landing pads LP, respectively. The data storage patterns DSP may be electrically connected to the channel layer CL through the landing pads LP.

In an embodiment, the data storage pattern DSP may be a capacitor. In this case, the data storage pattern DSP may include a bottom electrode, a top electrode, and a capacitor dielectric layer interposed therebetween.

In an embodiment, the data storage pattern DSP may be a variable resistance pattern whose resistance can be switched to one of at least two states by an electric pulse applied thereto. For example, the data storage pattern DSP may be formed of or include at least one of a phase-change material whose crystal state can be changed depending on an amount of a current applied thereto, a perovskite compound, a transition metal oxide, a magnetic material, a ferromagnetic material, or an antiferromagnetic material.

Referring to FIGS. 4D and 4E, a side surface S1 of the gate insulating layer GI and a side surface S2 of the first end portion EP1 of the word line WL may be in contact with a side surface S3 of the filling insulating layer 41. The side surface S3 of the filling insulating layer 41 may cover the side surface S1 of the gate insulating layer GI and the side surface S2 of the first end portion EP1 of the word line WL.

The side surface S3 of the filling insulating layer 41 may be spaced apart from the channel layer CL, which is adjacent to the filling insulating layer 41, in the first direction D1. The channel layer CL, which is adjacent to the filling insulating layer 41, may not overlap the upper portion 31b of the first interlayer insulating layer 31 in the third direction D3. The channel layer CL, which is adjacent to the filling insulating layer 41, may be spaced apart from the upper portion 31b of the first interlayer insulating layer 31 in the first direction D1.

The intervening portion IN of the division structure DS may include a first side surface S4 in contact with the landing pad LP and a second (e.g., opposing) side surface S5 in contact with the first connection pad 43. A length of the first and second side surfaces S4 and S5 of the intervening portion IN in the third direction D3 may be larger than a length of the first connection pad 43 in the third direction D3. For example, a lower portion of the intervening portion IN may be disposed in the gate capping pattern GP. That is, the intervening portion IN of the division structure DS may extend towards the substrate SUB beyond (i.e., to a greater depth than) the first connection pad 43. A bottom surface of the intervening portion IN of the division structure DS may be lower than a bottom surface of the first connection pad 43.

A top surface S6 of the intervening portion IN of the division structure DS, a top surface S7 of the first connection pad 43, and a top surface S8 of the landing pad LP may be coplanar with each other. The top surface S6 of the intervening portion IN of the division structure DS, the top surface S7 of the first connection pad 43, and the top surface S8 of the landing pad LP may be placed at the same level (e.g., relative to the substrate SUB) in the third direction D3. The top surface S7 of the first connection pad 43 may be a top surface of the conductive layer CO of the first connection pad 43. The top surface S8 of the landing pad LP may be a top surface of the conductive layer CO of the landing pad LP.

The landing pad LP may include a lower portion LPa and an upper portion LPb. The lower portion LPa of the landing pad LP may be in contact with the channel layer CL. A width of the upper portion LPb of the landing pad LP in the second direction D2 may be larger than a width of the lower portion LPa of the landing pad LP in the second direction D2.

The barrier layer BA of the landing pad LP may include a first portion and a second portion. Here, the first portion of the barrier layer BA may be included in the lower portion LPa of the landing pad LP, and the second portion of the barrier layer BA may be included in the upper portion LPb of the landing pad LP. The conductive layer CO of the landing pad LP may include a first portion and a second portion. Here, the first portion of the conductive layer CO may be included in the lower portion LPa of the landing pad LP, and the second portion of the conductive layer CO may be included in the upper portion LPb of the landing pad LP. The first portion of the barrier layer BA of the landing pad LP may enclose the first portion of the conductive layer CO of the landing pad LP.

The lower portion LPa of the landing pad LP may be disposed at a level lower than the first connection pad 43. The first portion of the barrier layer BA of the landing pad LP may be disposed at a level lower than the first connection pad 43. The first portion of the conductive layer CO of the landing pad LP may be disposed at a level lower than the first connection pad 43. The upper portion LPb of the landing pad LP may be disposed at the same level as the first connection pad 43. A bottom surface S9 of the first connection pad 43 may be placed at the same level as a bottom surface S10 of the upper portion LPb of the landing pad LP in the third direction D3. The bottom surface S9 of the first connection pad 43 may be coplanar with the bottom surface S10 of the upper portion LPb of the landing pad LP. The bottom surface S9 of the first connection pad 43 may be in contact with a top surface of the penetration contact 42 and a top surface of the gate capping pattern GP. The bottom surface S10 of the upper portion LPb of the landing pad LP may be in contact with a top surface of the gate capping pattern GP, a top surface of the gate insulating layer GI, and a top surface of the second molding insulating layer 45. The bottom surface S9 of the first connection pad 43 may be a bottom surface of the barrier layer BA of the first connection pad 43.

A side surface S11 of the upper portion 31b of the first interlayer insulating layer 31 may be in contact with a side surface S12 of the second interlayer insulating layer 32. A top surface S13 of the bit line BL may be coplanar with a top surface S14 of the conductive connection pattern 37. The top surface S13 of the bit line BL may be placed at the same level as the top surface S14 of the conductive connection pattern 37 in the third direction D3. The top surface S14 of the conductive connection pattern 37 may be in contact with the gate insulating layer GI.

In the semiconductor device according to an embodiment of the inventive concept, the word line WL and the second transistor TR2 may be electrically connected to each other through the connection pad 43 or 44 and the respective penetration contact 42. Thus, a length of an electrical conduction path between the word line WL and the second transistor TR2 may be relatively reduced, and this may make it possible to increase an integration density of the semiconductor device and the signal transmission speed between the word line WL and the second transistor TR2.

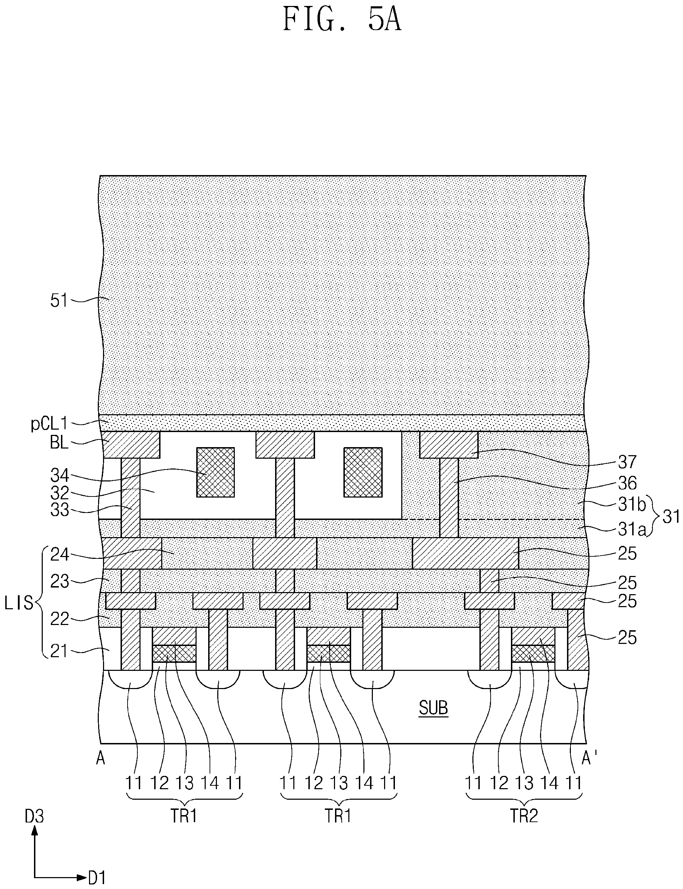

FIGS. 5A, 5B, 6A, 6B, 7A, 7B, 8A, 8B, 9, 10, 11A, 11B, 12, and 13 are sectional views illustrating a method of fabricating a semiconductor device, according to an embodiment of the inventive concept.

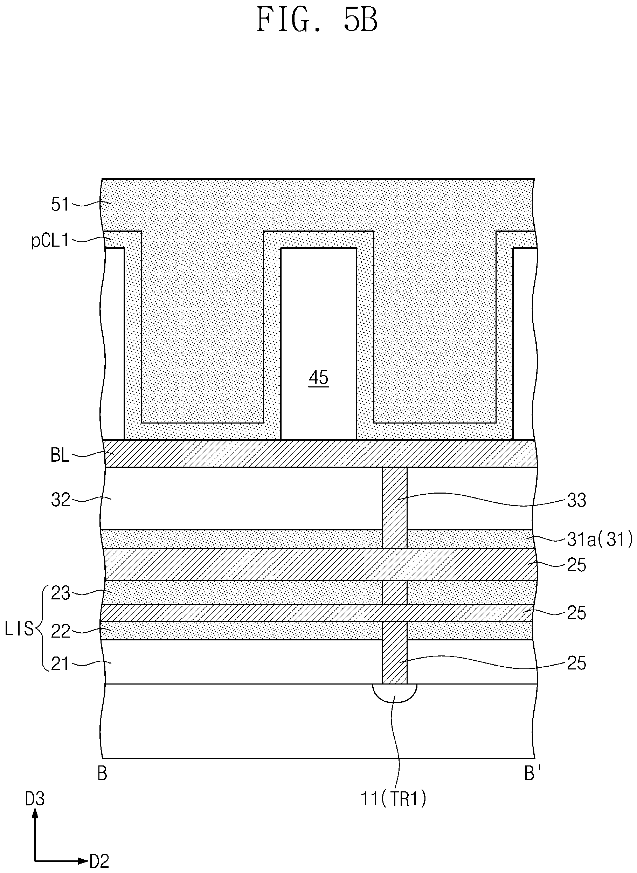

Referring to FIGS. 5A and 5B, the lower insulating structure LIS, the first transistor TR1, and the second transistor TR2 may be formed on the substrate SUB. The lower conductive patterns 25 may be formed in the lower insulating structure LIS.

The first interlayer insulating layer 31 may be formed on the lower insulating structure LIS. The second interlayer insulating layer 32 may be formed in the first interlayer insulating layer 31. In an embodiment, the formation of the second interlayer insulating layer 32 may include etching the first interlayer insulating layer 31 to form an empty space and forming the second interlayer insulating layer 32 in the empty space.

The first and second contacts 33 and 36 may be formed. The bit line BL and the conductive connection pattern 37 may be formed, e.g., from portions of a same conductive layer. The shielding pattern 34 may be formed.

The second molding insulating layers 45 may be formed. The second molding insulating layers 45, which are placed on one of the bit lines BL, may be arranged in the second direction D2.

A first preliminary channel layer pCL1 may be conformally formed on the upper portion 31b of the first interlayer insulating layer 31, the second interlayer insulating layer 32, the bit line BL, the conductive connection pattern 37, and the second molding insulating layer 45. The first preliminary channel layer pCL1 may cover the upper portion 31b of the first interlayer insulating layer 31, the second interlayer insulating layer 32, the bit line BL, the conductive connection pattern 37, and the second molding insulating layer 45. The first preliminary channel layer pCL1 may be formed of or include at least one semiconductor material or oxide semiconductor material.

A first sacrificial layer 51 may be formed on the first preliminary channel layer pCL1. The first sacrificial layer 51 may cover the first preliminary channel layer pCL1. The first sacrificial layer 51 may be formed of or include at least one insulating material. As an example, the first sacrificial layer 51 may be formed of or include at least one spin-on-hardmask (SOH) material.

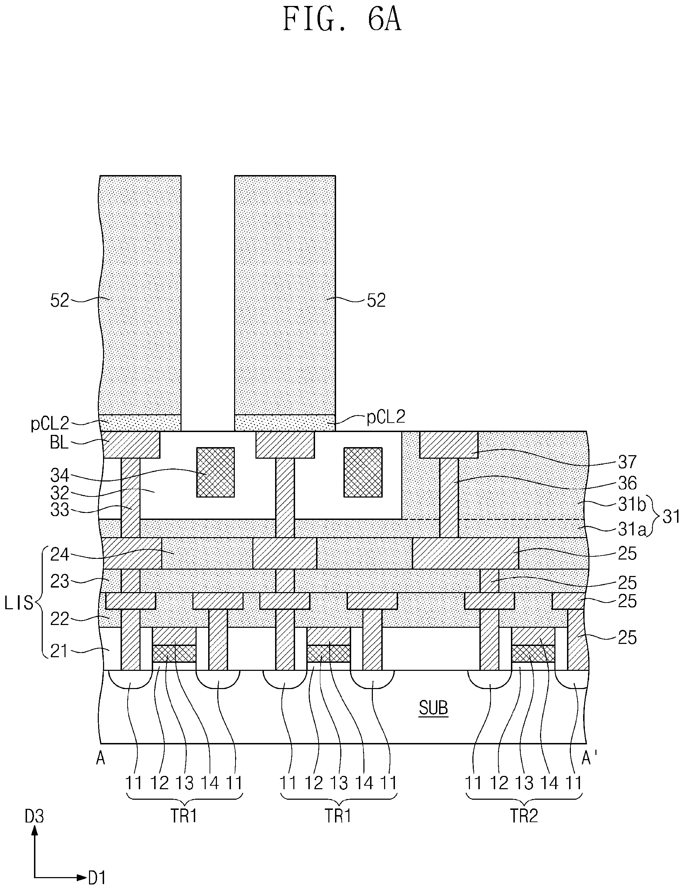

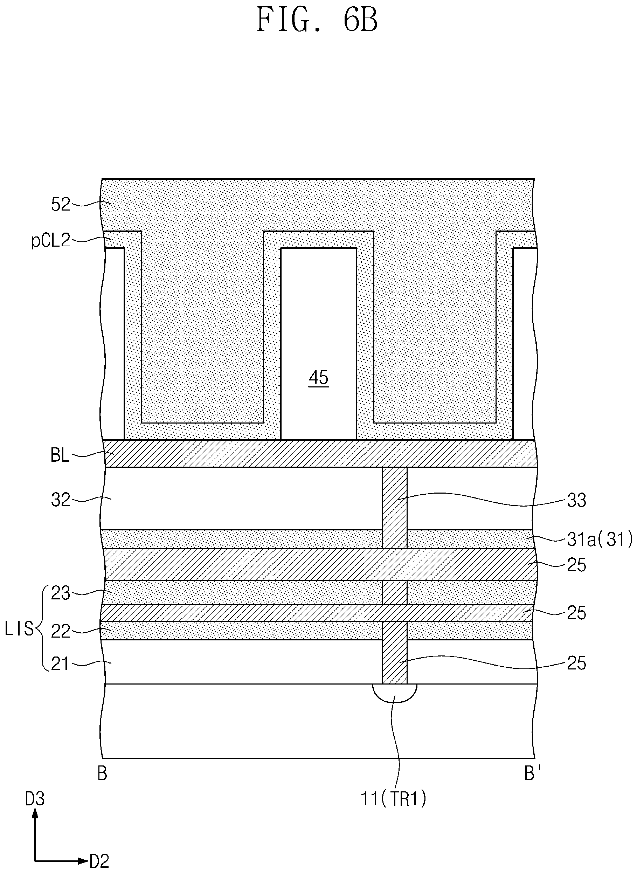

Referring to FIGS. 6A and 6B, the first sacrificial layer 51 may be patterned to form second sacrificial layers 52. The first sacrificial layer 51 may be divided into the second sacrificial layers 52. The second sacrificial layers 52 may be spaced apart from each other in the first direction D1. A portion of the first sacrificial layer 51, which overlaps the upper portion 31b of the first interlayer insulating layer 31 in the third direction D3, may be removed during the patterning process on the first sacrificial layer 51.

The first preliminary channel layer pCL1 may be patterned using the second sacrificial layers 52 as an etch mask. As a result of the patterning of the first preliminary channel layer pCL1, second preliminary channel layers pCL2 may be formed. The first preliminary channel layer pCL1 may be divided into the second preliminary channel layers pCL2. The second preliminary channel layers pCL2 may be spaced apart from each other in the first direction D1. A portion of the first preliminary channel layer pCL1, which is overlaps the upper portion 31b of the first interlayer insulating layer 31 in the third direction D3, may be removed during the pattering process on the first preliminary channel layer pCL1. A portion of the first preliminary channel layer pCL1, which overlaps the conductive connection pattern 37 in the third direction D3, may be removed during the patterning process on the first preliminary channel layer pCL1.

The second preliminary channel layer pCL2 may be formed on the bit line BL. The first preliminary channel layer pCL1 may be patterned to expose the conductive connection pattern 37.

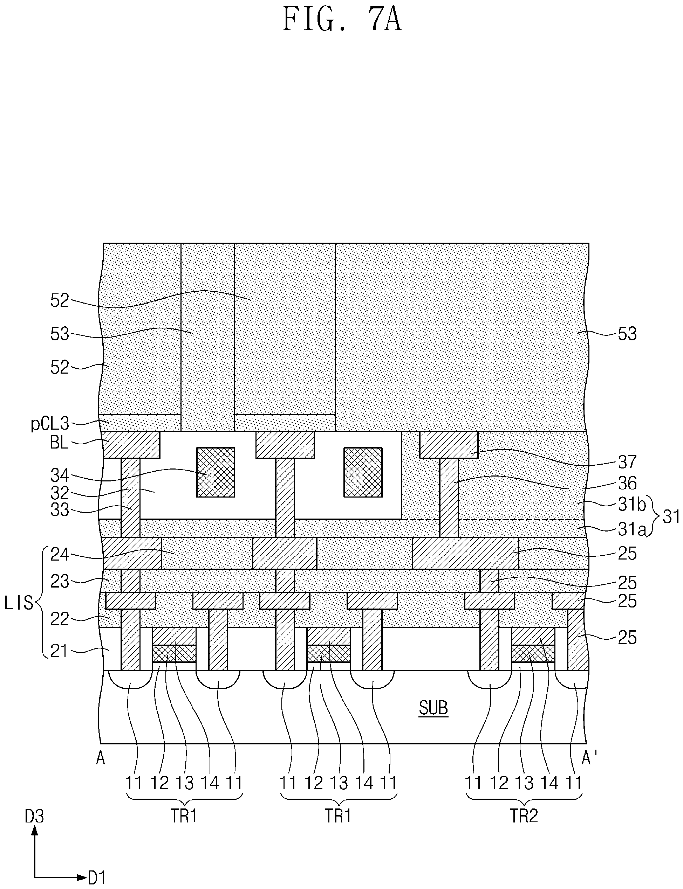

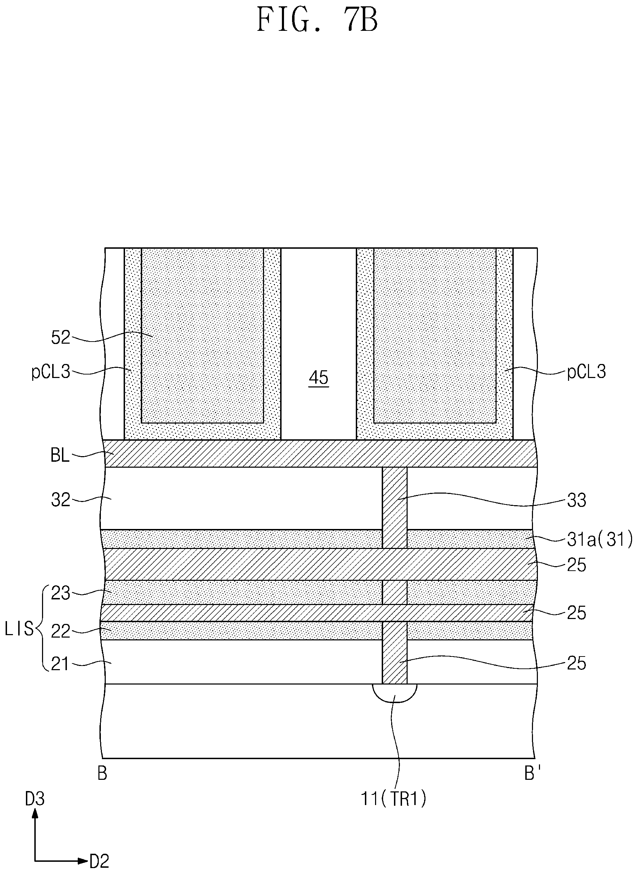

Referring to FIGS. 7A and 7B, a third sacrificial layer 53 may be formed. The third sacrificial layer 53 may be formed of or include at least one insulating material. As an example, the third sacrificial layer 53 may be formed of or include a spin-on-hardmask (SOH) material. The third sacrificial layer 53 may cover the conductive connection pattern 37, the upper portion 31b of the first interlayer insulating layer 31, and the second sacrificial layers 52.

A removal process may be performed to remove an upper portion of the third sacrificial layer 53, upper portions of the second sacrificial layers 52, and upper portions of the second preliminary channel layers pCL2. In an embodiment, the removal process may include a chemical mechanical polishing step.

As a result of the removal of the upper portions of the second preliminary channel layers pCL2, third preliminary channel layers pCL3 may be formed. For example, the second preliminary channel layer pCL2 may be divided into the third preliminary channel layers pCL3 that are separated from each other.

In an embodiment, the removal process may be performed to expose a top surface of the third preliminary channel layer pCL3 and a top surface of the second molding insulating layer 45.

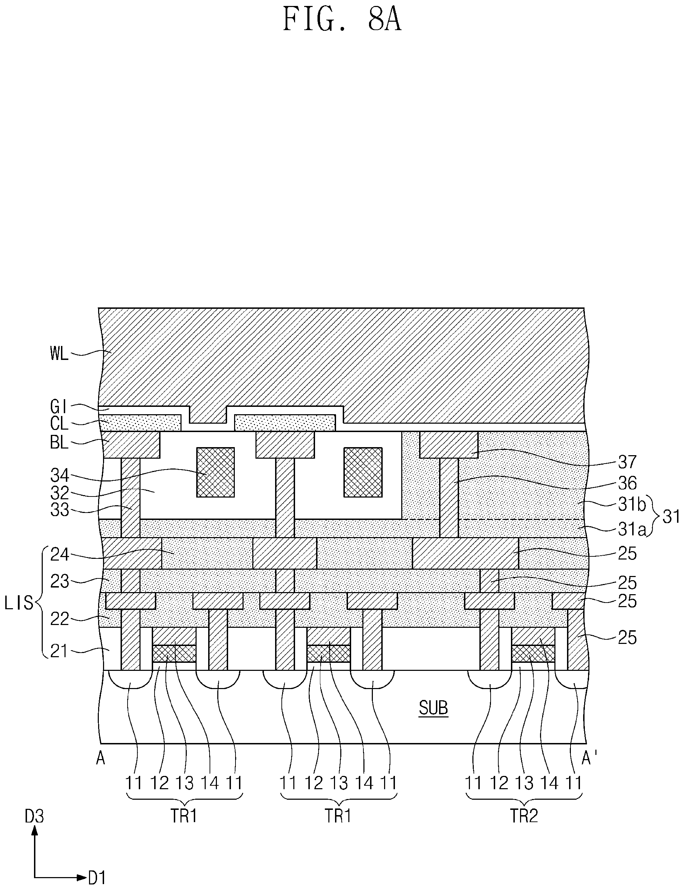

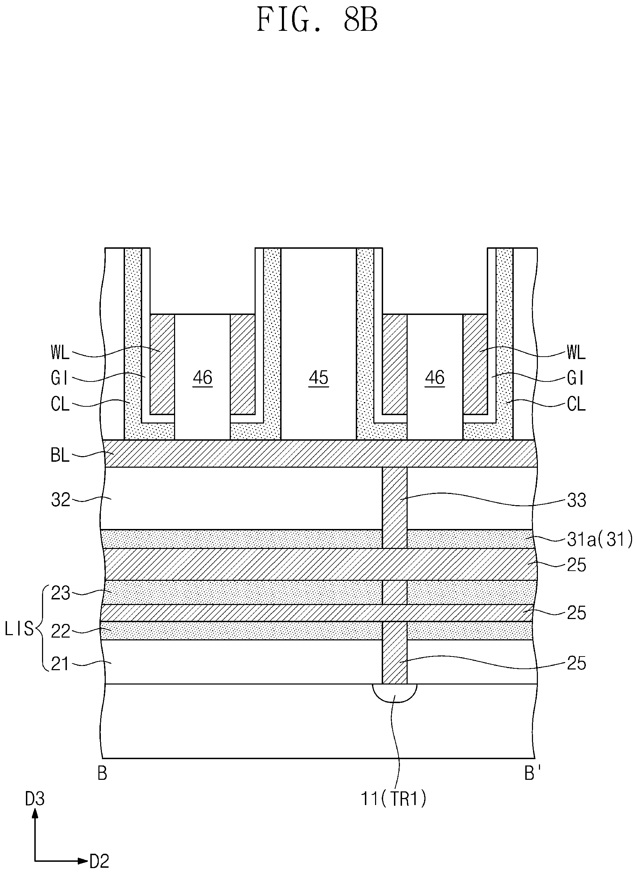

Referring to FIGS. 8A and 8B, the second sacrificial layer 52 and the third sacrificial layer 53 may be removed. In an embodiment, the second and third sacrificial layers 52 and 53 may be removed by a strip process. The removal of the second and third sacrificial layers 52 and 53 may be performed to expose the third preliminary channel layers pCL3, the upper portion 31b of the first interlayer insulating layer 31, and the conductive connection pattern 37.

The gate insulating layer GI, the word line WL, and the channel layer CL may be formed. The formation of the gate insulating layer GI, the word line WL, and the channel layer CL may include forming a preliminary gate insulating layer to cover the third preliminary channel layers pCL3, the upper portion 31b of the first interlayer insulating layer 31, and the conductive connection pattern 37, forming a preliminary word line layer on the preliminary gate insulating layer, performing an anisotropic etching process on the preliminary word line layer to form the word lines WL, and performing an anisotropic etching process on the preliminary gate insulating layer and the third preliminary channel layer pCL3 to form the gate insulating layers GI and the channel layers CL.

As a result of the etching process, the preliminary word line layer may be divided into the word lines WL that are separated from each other. As a result of the etching process, the preliminary gate insulating layer may be divided into the gate insulating layers GI that are separated from each other. As a result of the etching process, the third preliminary channel layer pCL3 may be divided into the channel layers CL that are separated from each other.

The first molding insulating layer 46 may be formed between the word lines WL. The formation of the first molding insulating layer 46 may include forming a preliminary insulating layer to cover the word lines WL and removing an upper portion of the preliminary insulating layer. The first molding insulating layer 46 may be formed as a result of the removal of the upper portion of the preliminary insulating layer.

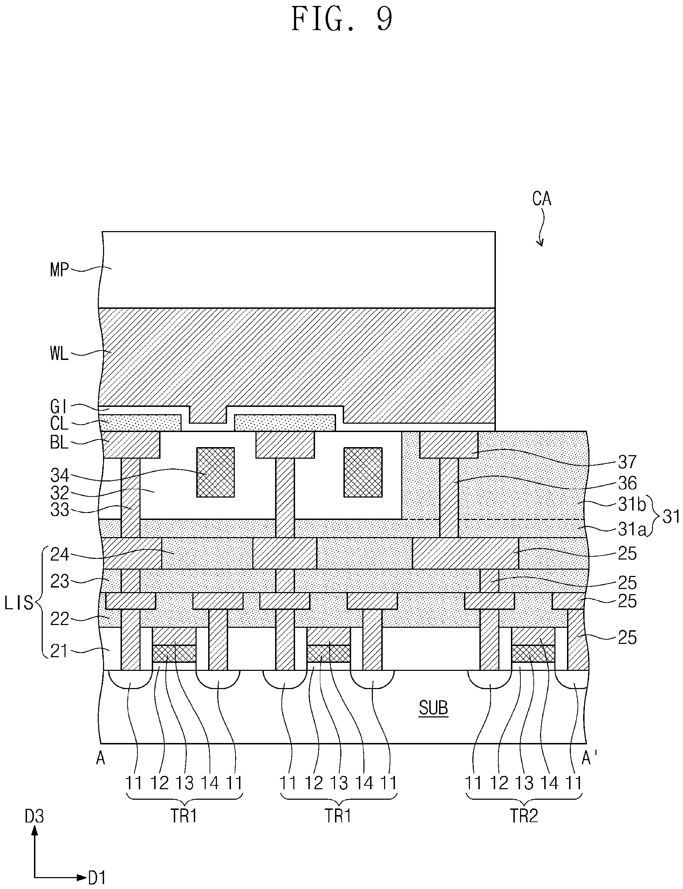

Referring to FIG. 9, a mask pattern MP may be formed on the word line WL. The mask pattern MP may be formed of or include at least one of, for example, a photoresist material or an insulating material. The word line WL and the gate insulating layer GI may be etched using the mask pattern MP as an etch mask. As a result of the etching of the word line WL and the gate insulating layer GI, the upper portion 31b of the first interlayer insulating layer 31 may be partially exposed. In an embodiment, an empty space, which will be referred to as a cavity CA, may be formed by the etching of the word line WL and the gate insulating layer GI.

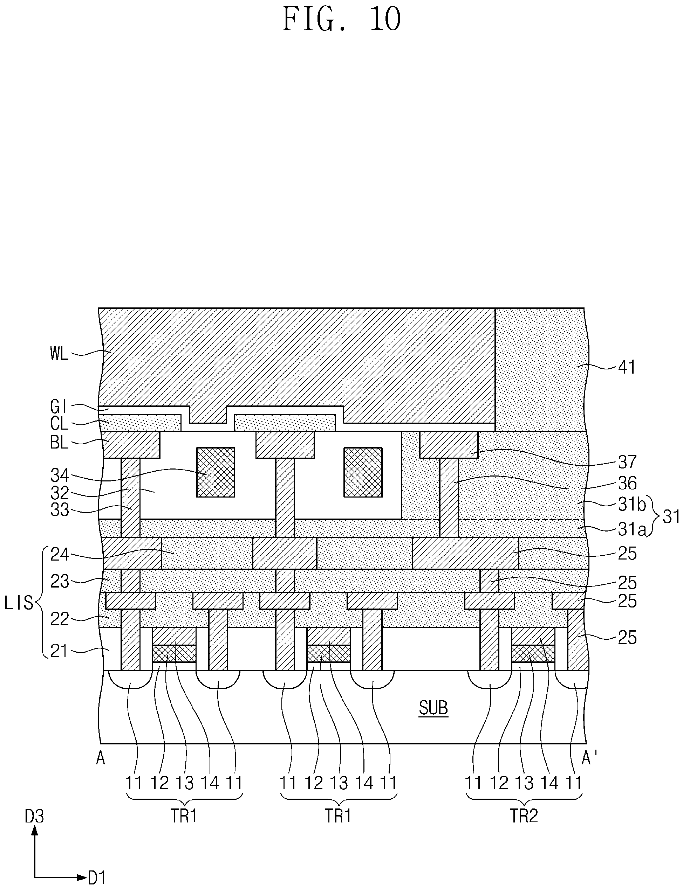

Referring to FIG. 10, the filling insulating layer 41 may be formed. The filling insulating layer 41 may fill the cavity CA. The filling insulating layer 41 may be formed on the upper portion 31b of the first interlayer insulating layer 31. In an embodiment, the formation of the filling insulating layer 41 may include forming a preliminary filling insulating layer to cover the word line WL and removing an upper portion of the preliminary filling insulating layer to expose the top surface of the word line WL.

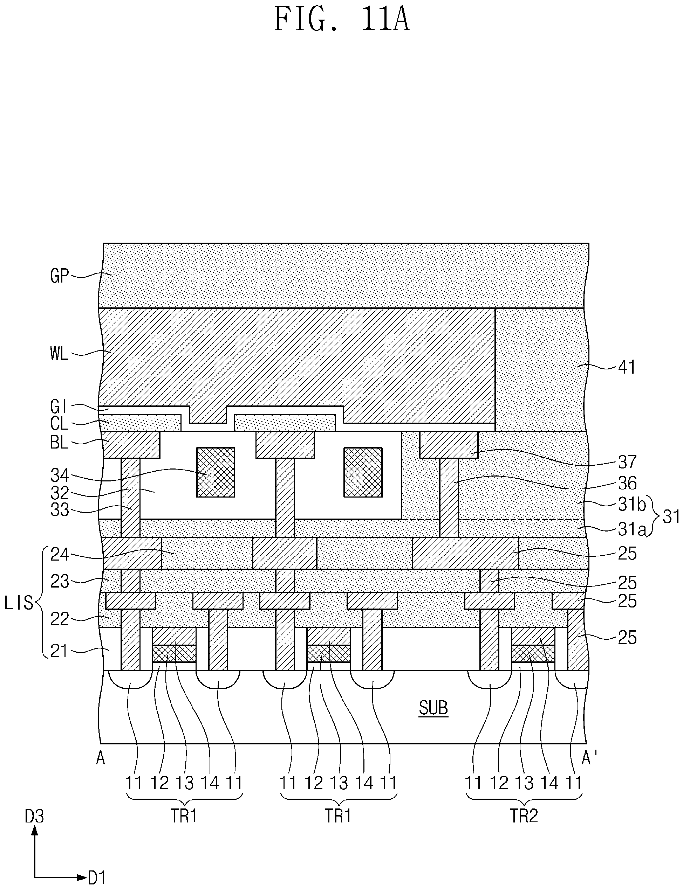

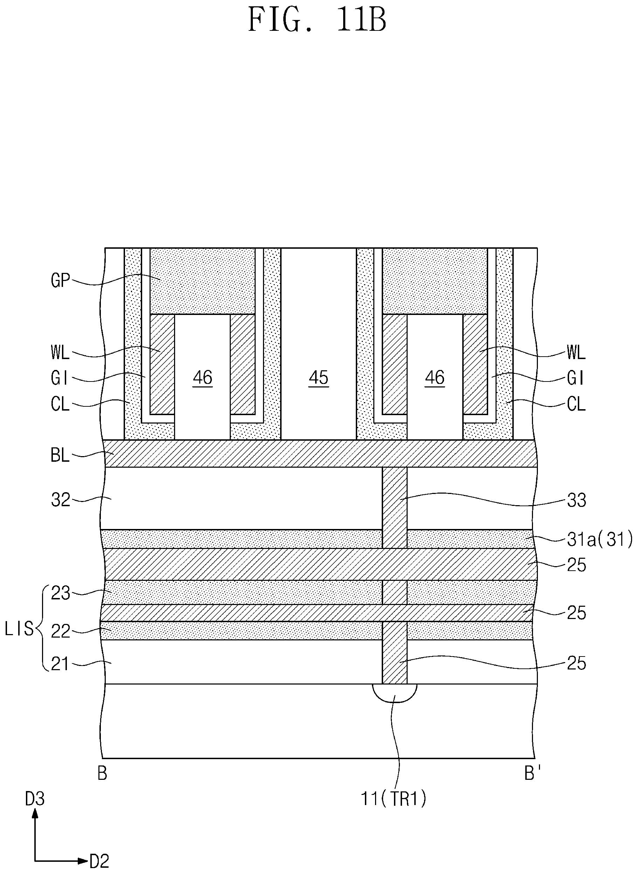

Referring to FIGS. 11A and 11B, the gate capping patterns GP may be formed. In an embodiment, the formation of the gate capping patterns GP may include forming a preliminary gate capping layer to cover the word lines WL, the channel layers CL, the gate insulating layers GI, the first molding insulating layers 46, and the second molding insulating layers 45 and removing an upper portion of the preliminary gate capping layer to form the gate capping patterns GP.

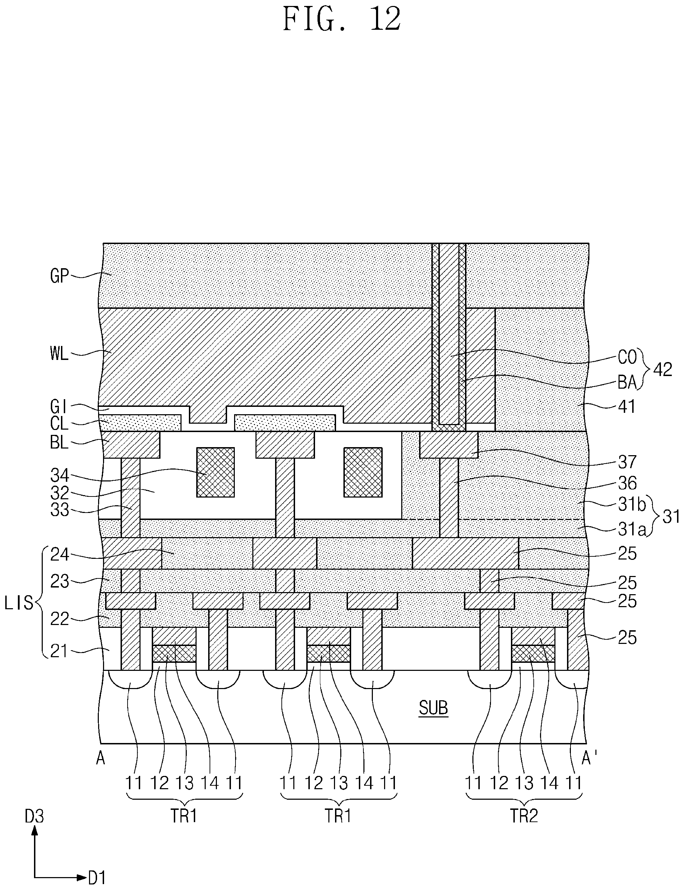

Referring to FIG. 12, the penetration contact 42 may be formed. The formation of the penetration contact 42 may include forming a penetration hole to penetrate the gate capping pattern GP, the word line WL, and the gate insulating layer GI and forming the penetration contact 42 in the penetration hole.

The barrier and conductive layers BA and CO of the penetration contact 42 may be sequentially formed in the penetration hole. A top surface of the conductive connection pattern 37 may be exposed through the penetration hole. The penetration contact 42 may be formed on the exposed top surface of the conductive connection pattern 37.

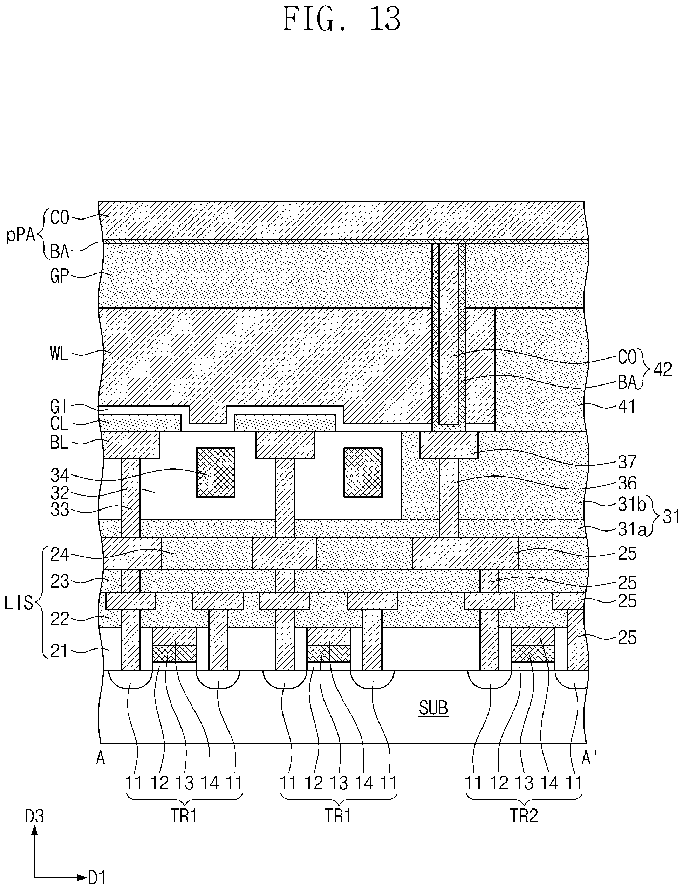

Referring to FIG. 13, a preliminary pad structure pPA may be formed. The preliminary pad structure pPA may be formed on a top surface of the gate capping pattern GP and a top surface of the penetration contact 42. The preliminary pad structure pPA may include the barrier layer BA and the conductive layer CO on the barrier layer BA.

Referring to FIGS. 4A, 4B, and 4C, the preliminary pad structure pPA may be patterned to form the landing pads LP, the first connection pads 43 and the second connection pads 44. The preliminary pad structure pPA may be divided into the landing pad LP, the first connection pad 43, and the second connection pad 44. That is, the landing pads LP and the connection pads 43, 44 may be formed from portions of the same conductive layer(s) pPA. In an embodiment, the gate capping pattern GP may also be patterned during the process of patterning the preliminary pad structure pPA.

The division structure DS may be formed in an empty space, which is formed by patterning the preliminary pad structure pPA.

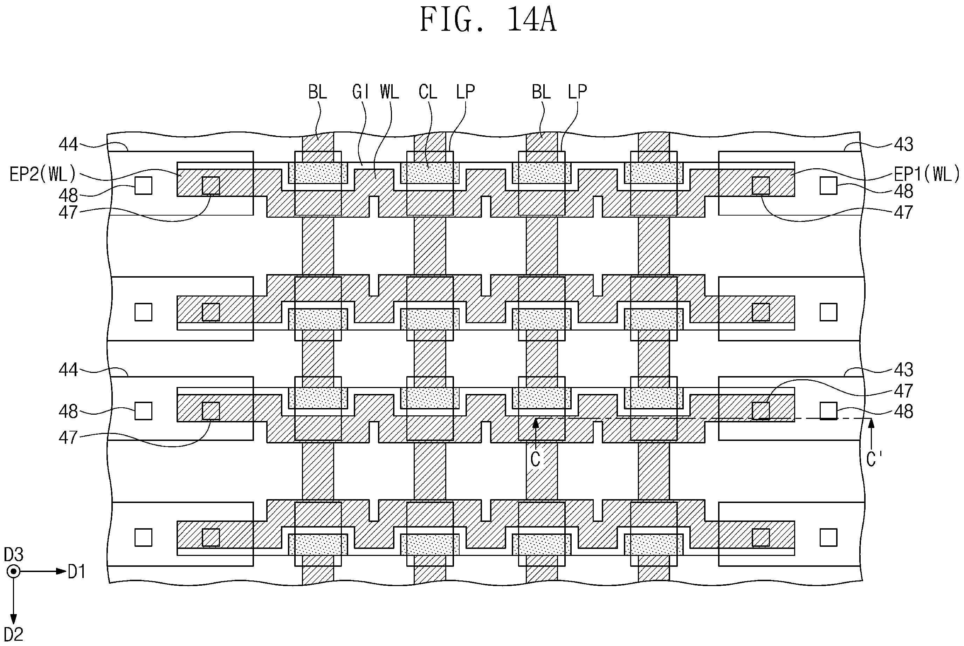

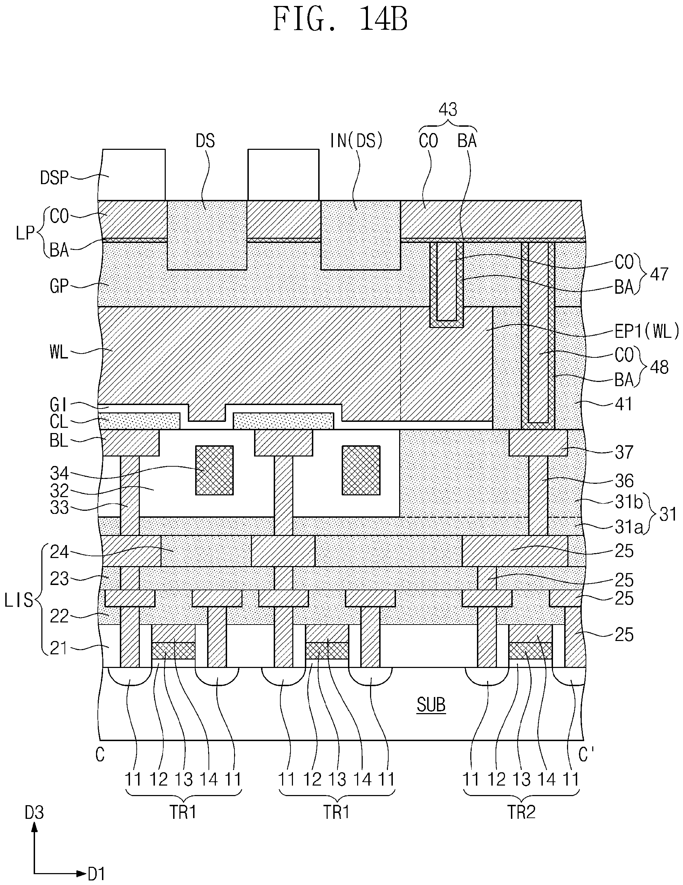

FIG. 14A is a plan view illustrating a semiconductor device according to an embodiment of the inventive concept. FIG. 14B is a sectional view taken along a line C-C' of FIG. 14A. Except for technical features to be described below, the semiconductor device of FIG. 14A and 14B may be provided to have technical features that are similar to the semiconductor device described with reference to FIG. 4A to 4E.

Referring to FIGS. 14A and 14B, the semiconductor device may include first connection contacts 47 and second connection contacts 48. The first connection contact 47 may electrically connect the first or second connection pad 43 or 44 to the word line WL. The first connection contact 47 may penetrate the gate capping pattern GP. The gate capping pattern GP may enclose the first connection contact 47. The lowermost portion of the first connection contact 47 may be disposed in the word line WL.

The second connection contact 48 may electrically connect the first or second connection pad 43 or 44 to a respective conductive connection pattern 37. The first connection pad 43 or the second connection pad 44 may be electrically connected to a respective second transistor TR2 through the second connection contact 48, the conductive connection pattern 37, and the lower conductive patterns 25. The second connection contact 48 may penetrate the gate capping pattern GP and the filling insulating layer 41. The filling insulating layer 41 and the gate capping pattern GP may enclose the second connection contact 48. A bottom surface of the second connection contact 48 may be in contact with a top surface of the conductive connection pattern 37.

A length of the first connection contact 47 in the third direction D3 may be less than a length of the second connection contact 48 in the third direction D3.

Each of the first and second connection contacts 47 and 48 may include the barrier layer BA and the conductive layer CO on the barrier layer BA. The formation of the first connection contact 47 may include forming a first penetration hole to penetrate the gate capping pattern GP and forming the first connection contact 47 in the first penetration hole. The formation of the second connection contact 48 may include forming a second penetration hole to penetrate the gate capping pattern GP and the filling insulating layer 41 and forming the second connection contact 48 in the second penetration hole.

The conductive connection pattern 37 may overlap the filling insulating layer 41 in the third direction D3. The conductive connection pattern 37 may not overlap the word line WL in the third direction D3. The conductive connection pattern 37 may be offset from the wordline WL along a horizontal direction (e.g. the first direction D1).

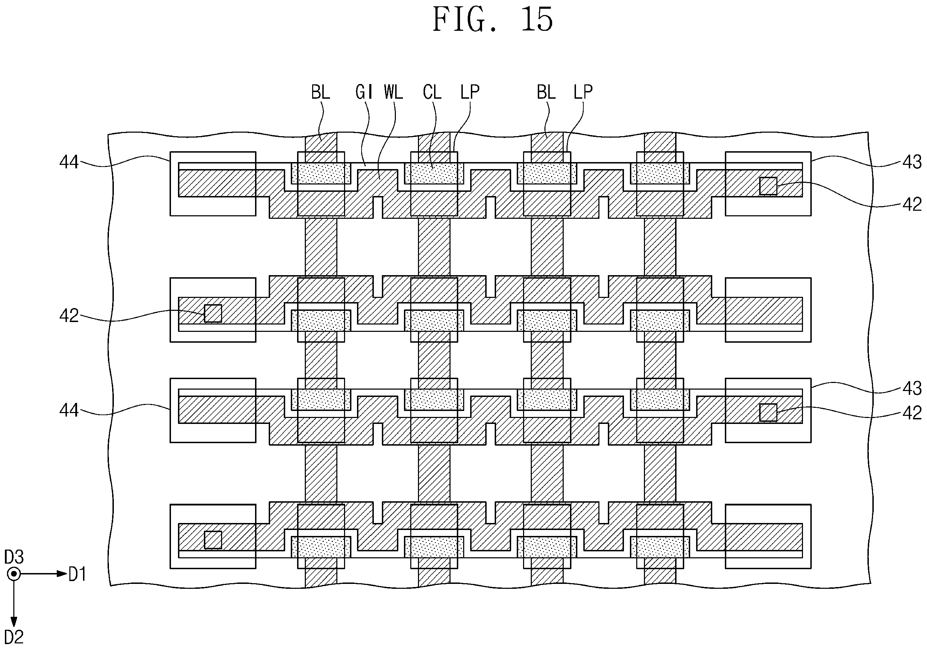

FIG. 15 is a plan view illustrating a semiconductor device according to an embodiment of the inventive concept. Except for technical features to be described below, the semiconductor device of FIG. 15 may be provided to have technical features that are similar to the semiconductor device described with reference to FIG. 4A to 4E.

Referring to FIG. 15, the first connection pads 43, which are connected to a respective penetration contact 42, and the first connection pads 43, which are not connected to a respective penetration contact 42, may be alternately arranged in the second direction D2. The second connection pads 44, which are connected to a respective penetration contact 42, and the second connection pads 44, which are not connected to a respective penetration contact 42, may be alternately arranged in the second direction D2.

A respective penetration contact 42 may be connected to one of the first and second connection pads 43 and 44, which overlap one of the word lines WL in the third direction D3. Among the first and second connection pads 43 and 44 overlapped with one of the word lines WL in the third direction D3, one may be electrically connected to the word line WL, and the other may be electrically isolated or disconnected from the word line WL.

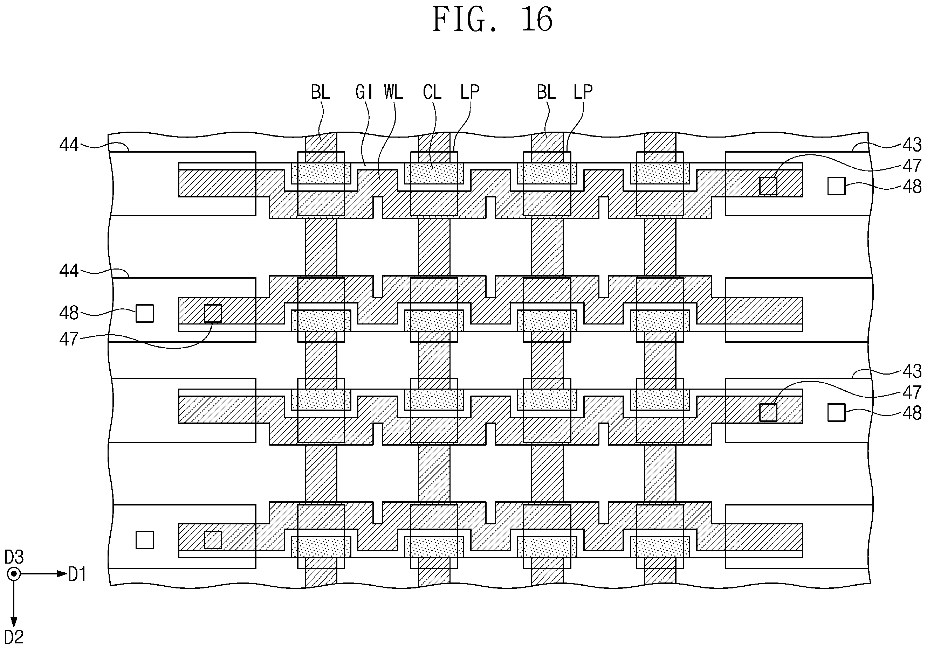

FIG. 16 is a plan view illustrating a semiconductor device according to an embodiment of the inventive concept. Except for technical features to be described below, the semiconductor device of FIG. 16 may be provided to have technical features that are similar to the semiconductor device described with reference to FIG. 14A and 14B.

Referring to FIG. 16, the first connection pads 43, which are connected to respective first and second connection contacts 47 and 48, and the first connection pads 43, which are not connected to respective first and second connection contacts 47 and 48, may be alternately arranged in the second direction D2. The second connection pads 44, which are connected to respective first and second connection contacts 47 and 48, and the second connection pads 44, which are not connected to respective first and second connection contacts 47 and 48, may be alternately arranged in the second direction D2.

Respective first and second connection contacts 47 and 48 may be connected to one of the first and second connection pads 43 and 44, which overlap one of the word lines WL in the third direction D3. Among the first and second connection pads 43 and 44 overlapping one of the word lines WL in the third direction D3, one may be electrically connected to the word line WL, and the other may be electrically isolated or disconnected from the word line WL.

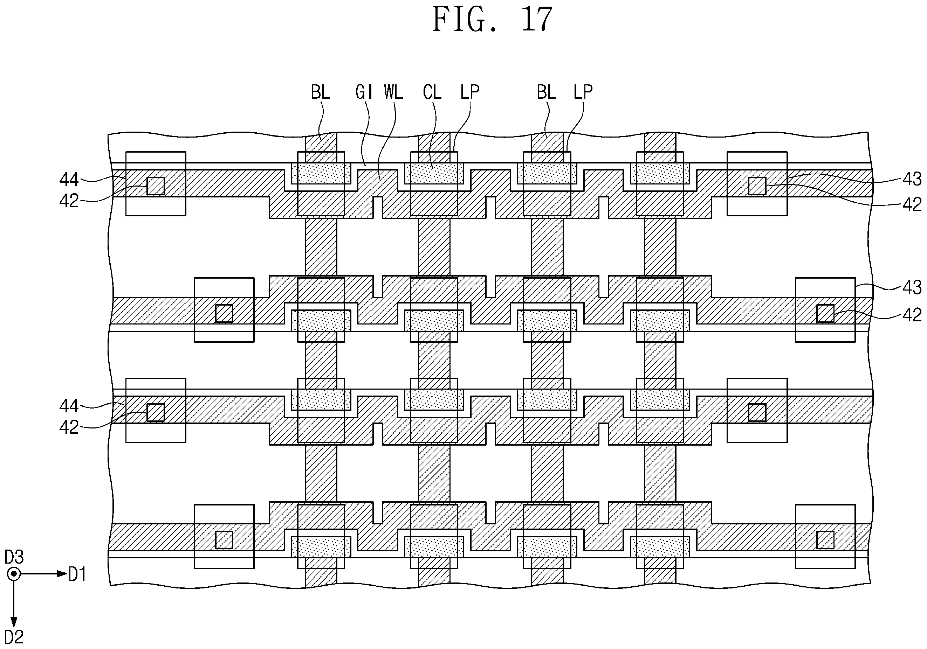

FIG. 17 is a plan view illustrating a semiconductor device according to an embodiment of the inventive concept. Except for technical features to be described below, the semiconductor device of FIG. 17 may be provided to have technical features that are similar to the semiconductor device described with reference to FIG. 4A to 4E.

Referring to FIG. 17, the first connection pads 43 may be disposed in a zigzag shape when viewed in plan view. The first connection pads 43 may be arranged such that adjacent ones of the first connection pads 43 are offset from each other in the first direction D1 or in the second direction D2. The second connection pads 44 may be disposed in a zigzag shape. The second connection pads 44 may be arranged such that adjacent ones of the second connection pads 44 are offset from each other in the first direction D1 or in the second direction D2.

In the case where the first and second connection pads 43 and 44 are disposed in the zigzag shape, it may be possible to reduce a difficulty in the process of forming the first and second connection pads 43 and 44.

According to an embodiment of the inventive concept, a semiconductor device may include a connection pad configured to reduce a length of an electrical conduction path between a word line and a transistor. This may increase an integration density of the semiconductor device and increase a signal transmission speed between the word line and the transistor.

Embodiments are set out in the following clauses:
Clause 1. A semiconductor device, comprising:
   a substrate;
   a first transistor and a second transistor on the substrate;
   a bit line electrically connected to the first transistor;
   a channel layer on the bit line;
   a gate insulating layer on the channel layer;
   a word line on the gate insulating layer;
   a landing pad electrically connected to the channel layer; and
   a first connection pad electrically connected to the word line and the second transistor,
   wherein the first connection pad overlaps a first end portion of the word line in plan view, and
   a top surface of the landing pad is at a substantially same level as a top surface of the first connection pad relative to the substrate.
Clause 2. The semiconductor device of clause 1, further comprising:
   a second connection pad that overlaps a second end portion of the word line in plan view,
   wherein the channel layer is between the first and second end portions of the word line, and the landing pad is between the first and second connection pads in plan view.
Clause 3. The semiconductor device of clause 2, wherein the second connection pad is electrically isolated from the word line.
Clause 4. The semiconductor device of any preceding clause, further comprising a penetration contact penetrating the first end portion of the word line and the gate insulating layer.
Clause 5. The semiconductor device of clause 4, further comprising a conductive connection pattern in contact with a bottom surface of the penetration contact,
   wherein the conductive connection pattern electrically connects the second transistor to the penetration contact.
Clause 6. The semiconductor device of clause 5, wherein a top surface of the conductive connection pattern is in contact with the gate insulating layer.
Clause 7. The semiconductor device of any preceding clause, wherein the landing pad comprises a lower portion, which is in contact with the channel layer, and an upper portion, which is wider than the lower portion, and
   a bottom surface of the upper portion of the landing pad is at a substantially same level as a bottom surface of the first connection pad, relative to the substrate.
Clause 8. The semiconductor device of any preceding clause, further comprising:
   a gate capping pattern on a top surface of the word line,
   wherein the first connection pad and the landing pad are in contact with the gate capping pattern.
Clause 9. The semiconductor device of clause 8, further comprising:
   a filling insulating layer on a side surface of the word line;
   a first connection contact penetrating the gate capping pattern and electrically connecting the word line to the first connection pad; and
   a second connection contact penetrating the gate capping pattern and the filling insulating layer and electrically connecting the first connection pad to the second transistor.
Clause 10. A semiconductor device, comprising:
   a substrate;
   a first transistor and a second transistor on the substrate;
   a lower insulating structure on the first transistor and the second transistor;
   a first interlayer insulating layer on the lower insulating structure;
   a second interlayer insulating layer on the first interlayer insulating layer;
   a bit line in the second interlayer insulating layer;
   a conductive connection pattern in the first interlayer insulating layer;
   a channel layer on the bit line;
   a gate insulating layer on the channel layer;
   a word line on the gate insulating layer;
   a gate capping pattern on the word line;
   a landing pad and a connection pad on the gate capping pattern;
   a division structure separating the landing pad from the connection pad; and
   a data storage pattern on the landing pad,
   wherein the landing pad is electrically connected to the first transistor through the channel layer and the bit line,
   the connection pad is electrically connected to the word line, and
   the connection pad is electrically connected to the second transistor through the conductive connection pattern.
Clause 11. The semiconductor device of clause 10, wherein the first interlayer insulating layer comprises a lower portion and an upper portion,
   the second interlayer insulating layer is on the lower portion of the first interlayer insulating layer,
   the upper portion of the first interlayer insulating layer is in contact with a side surface of the second interlayer insulating layer, and
   the conductive connection pattern is in the upper portion of the first interlayer insulating layer.
Clause 12. A method of fabricating a semiconductor device, comprising:
   forming a first transistor and a second transistor on a substrate;
   forming a bit line and a conductive connection pattern, which are electrically connected to the first transistor and the second transistor, respectively;
   forming a channel layer on the bit line;
   forming a gate insulating layer on the channel layer;
   forming a word line on the gate insulating layer;
   forming a gate capping pattern on the word line;
   forming a preliminary pad structure on the gate capping pattern; and
   patterning the preliminary pad structure to form a landing pad and a connection pad,
   wherein the landing pad is electrically connected to the bit line, and
   the connection pad is electrically connected to the conductive connection pattern.
Clause 13. The method of clause 12, further comprising:
   forming a penetration hole to penetrate the gate capping pattern, the word line, and the gate insulating layer and expose the conductive connection pattern; and
   forming a penetration contact in the penetration hole,
   wherein the penetration contact electrically connects the connection pad to the word line and to the conductive connection pattern.
Clause 14. The method of clause 13, wherein the preliminary pad structure is on a top surface of the penetration contact.
Clause 15. The method of any of clauses 12-14, further comprising:
   forming a mask pattern on the word line;
   etching the word line and the gate insulating layer using the mask pattern as an etch mask; and
   forming a filling insulating layer on a side surface of the word line and a side surface of the gate insulating layer.
Clause 16. The method of clause 15, when dependent on clause 12, further comprising:
   forming a first connection contact to penetrate the gate capping pattern and electrically connect the connection pad to the word line; and
   forming a second connection contact to penetrate the gate capping pattern and the filling insulating layer and electrically connect the connection pad to the conductive connection pattern.
Clause 17. The method of any of clauses 12-16, wherein the forming of the channel layer comprises:
   forming a first preliminary channel layer on the bit line and the conductive connection pattern;
   patterning the first preliminary channel layer to form second preliminary channel layers that are separated from each other;
   removing an upper portion of each of the second preliminary channel layers to form third preliminary channel layers; and
   performing an anisotropic etching process on each of the third preliminary channel layers to form channel layers.
Clause 18. The method of clause 17, wherein the patterning of the first preliminary channel layer comprises removing a portion of the first preliminary channel layer that overlaps the conductive connection pattern in plan view.
Clause 19. The method of any of clauses 12-18, further comprising, prior to forming the bit line and the conductive connection pattern:
   forming a first interlayer insulating layer; and
   forming a second interlayer insulating layer in the first interlayer insulating layer,
   wherein forming a bit line and a conductive connection pattern comprises forming the bit line in the second interlayer insulating layer, and forming the conductive connection pattern in the first interlayer insulating layer.

While example embodiments of the inventive concept have been particularly shown and described, it will be understood by one of ordinary skill in the art that variations in form and detail may be made therein without departing from the scope of the attached claims.

## Claims

1. A semiconductor device, comprising:
a substrate;
a first transistor and a second transistor on the substrate;
a bit line electrically connected to the first transistor;
a channel layer on the bit line;
a gate insulating layer on the channel layer;
a word line on the gate insulating layer;
a landing pad electrically connected to the channel layer;
a connection pad electrically connected to the word line and the second transistor; and
a division structure separating the landing pad from the connection pad,
wherein the division structure comprises an intervening portion between the landing pad and the connection pad, and
the intervening portion comprises a first side surface in contact with the landing pad and a second side surface in contact with the connection pad.

2. The semiconductor device of claim 1, wherein a top surface of the landing pad is at a substantially same level as a top surface of the connection pad relative to the substrate, wherein the landing pad and the connection pad comprise a same conductive material.

3. The semiconductor device of claim 1 or claim 2, further comprising:
a first connection contact electrically connecting the connection pad to the word line; and
a second connection contact electrically connecting the connection pad to the second transistor.

4. The semiconductor device of claim 3, further comprising a filling insulating layer extending around the second connection contact,
wherein the filling insulating layer is on a side surface of the word line and separates the second connection contact from the word line.

5. The semiconductor device of claim 4, further comprising a gate capping pattern between the word line and the connection pad,
wherein the first connection contact penetrates the gate capping pattern.

6. The semiconductor device of any of claims 3-5, further comprising a conductive connection pattern in contact with a bottom surface of the second connection contact,
wherein a top surface of the conductive connection pattern is located at a substantially same level as a top surface of the bit line, relative to the substrate.

7. The semiconductor device of claim 6, further comprising:
a lower insulating structure on the first and second transistors;
a first interlayer insulating layer on the lower insulating structure; and
a second interlayer insulating layer in the first interlayer insulating layer,
wherein the conductive connection pattern is in the first interlayer insulating layer, and the bit line is in the second interlayer insulating layer, and
wherein the conductive connection pattern and the bit line comprise a same conductive material.

8. The semiconductor device of claim 1 or claim 2, further comprising a penetration contact penetrating the word line and the gate insulating layer,
wherein the penetration contact electrically connects the connection pad, the word line, and the second transistor to each other.

9. The semiconductor device of claim 8, wherein the penetration contact further comprises a barrier layer in contact with the word line and a conductive layer, wherein the barrier layer is between the conductive layer and the word line.

10. A method of fabricating a semiconductor device, comprising:
forming a first transistor and a second transistor on a substrate;
forming a bit line and a conductive connection pattern, which are electrically connected to the first transistor and the second transistor, respectively;
forming a channel layer on the bit line;
forming a gate insulating layer on the channel layer;
forming a word line on the gate insulating layer;
forming a gate capping pattern on the word line;
forming a preliminary pad structure on the gate capping pattern; and
patterning the preliminary pad structure to form a landing pad and a connection pad,
wherein the landing pad is electrically connected to the bit line, and
the connection pad is electrically connected to the conductive connection pattern.

11. The method of claim 10, further comprising:
forming a penetration hole to penetrate the gate capping pattern, the word line, and the gate insulating layer and expose the conductive connection pattern; and
forming a penetration contact in the penetration hole,
wherein the penetration contact electrically connects the connection pad to the word line and to the conductive connection pattern.

12. The method of claim 11, wherein the preliminary pad structure is on a top surface of the penetration contact.

13. The method of any of claims 10-12, further comprising:
forming a mask pattern on the word line;
etching the word line and the gate insulating layer using the mask pattern as an etch mask; and
forming a filling insulating layer on a side surface of the word line and a side surface of the gate insulating layer.

14. The method of claim 13, when dependent on claim 10, further comprising:
forming a first connection contact to penetrate the gate capping pattern and electrically connect the connection pad to the word line; and
forming a second connection contact to penetrate the gate capping pattern and the filling insulating layer and electrically connect the connection pad to the conductive connection pattern.

15. The method of any of claims 10-14, wherein the forming of the channel layer comprises:
forming a first preliminary channel layer on the bit line and the conductive connection pattern;
patterning the first preliminary channel layer to form second preliminary channel layers that are separated from each other;
removing an upper portion of each of the second preliminary channel layers to form third preliminary channel layers; and
performing an anisotropic etching process on each of the third preliminary channel layers to form channel layers.
